# EUROPÄISCHE PATENTSCHRIFT

(11) **EP 0 646 188 B1**
(45) Veröffentlichungstag und Bekanntmachung des Hinweises auf die Patenterteilung: **17.04.1996**
(21) Anmeldenummer: 93911747.9
(22) Anmeldetag: 17.05.1993
(51) Int. Cl.: C25D 1/10

(54) **WERKZEUG UND VERFAHREN ZUR HERSTELLUNG EINER MIKROSTRUKTURIERTEN KUNSTSTOFFSCHICHT**
PROCESS AND TOOL FOR PRODUCING A MICROSTRUCTURED PLASTIC LAYER
OUTIL ET PROCEDE POUR LA FABRICATION D'UNE COUCHE EN MATIERE PLASTIQUE MICROSTRUCTUREE

(30) Priorität: 16.06.1992 DE 4219667
(43) Veröffentlichungstag der Anmeldung: 05.04.1995
(73) Patentinhaber: Forschungszentrum Karlsruhe GmbH, D-76133 Karlsruhe (DE)
(72) Erfinder: BACHER, Walter, D-7513 Stutensee (DE); BLEY, Peter, D-7514 Eggenstein-Leopoldshafen (DE); HARMENING, Michael, D-6945 Hirschberg (DE)
(74) Vertreter: Gottlob, Peter, Dipl. Ing.
(86) Internationale Anmeldenummer: DE9300426
(87) Internationale Veröffentlichungsnummer: WO9325732

(56) Entgegenhaltungen:
- EP-A- 0 148 377
- DE-A- 3 537 483
- DE-A- 4 010 669

## Beschreibung

Die Erfindung betrifft ein Werkzeug gemäß dem Oberbegriff von Anspruch 1 und ein Verfahren zur Herstellung einer mikrostrukturierten Kunststoffschicht gemäß Anspruch 2.

Ein solches Werkzeug und ein solches Verfahren sind aus der DE 35 37 483 C1 bekannt. In den Fig. 2 und 13 ist ein Werkzeug bestehend aus Mikrostrukturen und einer fest mit ihnen verbundenen Grundplatte dargestellt, wobei die Stirnflächen der Mikrostrukturen parallel zur Grundplatte verlaufen.

Ferner ist aus dieser Druckschrift ein Verfahren zum Herstellen einer Vielzahl plattenförmiger Mikrostrukturkörper aus Metall bekannt, bei dem durch wiederholtes Abformen eines die Mikrostrukturen aufweisenden Werkzeugs mit einer elektrisch isolierenden Abformmase Negativformen der Mikrostrukturen erzeugt werden, die galvanisch mit einem Metall aufgefüllt werden, wonach die Negativformen entfernt werden, bei dem eine Ausführungsform (Maßnahme b) dadurch gekennzeichnet ist, daß die elektrisch isolierende Abformmasse mit einer weiteren Schicht aus elektrisch leitender Abformmasse verbunden wird, wobei die Dicke der elektrisch isolierenden Abformmasse der Höhe der Mikrostrukturen entspricht in der Weise, daß die elektrisch leitende Abformmasse im Zuge des Abformens die Stirnflächen der Mikrostrukturen des Werkzeugs berührt.

Bei diesem Verfahren soll das die Mikrostrukturen tragende Werkzeug so weit durch die elektrisch isolierende Schicht der Verbundschicht gepreßt werden, bis die Stirnflächen der Mikrostrukturen die elektrisch leitende Schicht erreichen. Bei diesem Vorgang wird die Verbundschicht erwärmt. Für die Dicke der elektrisch isolierenden Schicht wird ein Wert von 0,3 mm angegeben. Beim Einpressen des Werkzeugs sollen die Stirnflächen der Mikrostrukturen die elektrisch leitende Schicht freilegen, so daß die elektrisch leitende Schicht als Elektrode geschaltet werden kann und die durch die Mikrostrukturen des Werkzeugs geschaffenen Vertiefungen galvanisch mit einem Metall aufgefüllt werden können.

Für die elektrisch leitende Schicht der Verbundschicht wird eine Formmasse bestehend aus PLEXIGLAS^{R} (Polymethylmethacrylat, PMMA) und 20 Gew.-% Leitruß vorgeschlagen; die elektrisch isolierende Schicht besteht aus reinem PLEXIGLAS^{R}.

Es hat sich gezeigt, daß bei diesem Verfahren vor allem dann, wenn die Stirnflächen der Mikrostrukturen des Werkzeugs relativ groß sind, die elektrisch leitende Schicht nicht oder nicht ausreichend freigelegt wird und daher nicht als Elektrode für die galvanische Abscheidung eines Metalls dienen kann. Die ebenen Stirnflächen des Werkzeugs können in diesem Fall die isolierende Schicht nicht durchstoßen. Dies trifft auch dann zu, wenn die isolierende Schicht eine Dicke von weniger als einem Zehntel der Höhe der Mikrostrukturen aufweist und die Mikrostrukturen des Werkzeugs vollständig in die Verbundschicht eingepreßt werden; auch dann verbleibt immer noch ein elektrisch isolierender Rest am Grund der durch das Werkzeug geschaffenen Vertiefungen in der Verbundschicht bestehen. Das Verfahren ist daher auf die Abformung von solchen Werkzeugen beschränkt, deren Mikrostrukturen sehr kleine Stirnflächen aufweisen.

Ein weiteres Verfahren zur Herstellung von galvanisch abformbaren Negativformen mikrostrukturierter, plattenförmiger Körper ist aus der DE 40 10 669 C1 bekannt. Bei diesem Verfahren wird ebenfalls eine Verbundschicht hergestellt, die aus einer elektrisch leitenden und einer isolierenden Schicht besteht. Das Werkzeug wird bei erhöhter Temperatur jedoch - im Gegensatz zu den Verfahren der eingangs genannten Art - durch den Film des elektrisch leitenden Materials hindurch in die nicht leitende Schicht eingedrückt. Bei diesem Verfahren soll die Schicht des leitendenden Materials etwa 50 nm bis 500 nm dick sein. Vor dem Beschichten mit dem leitenden Material soll die nicht leitende Kunststoffschicht etwa durch Mikrosandstrahlen aufgerauht werden. Beim Einpressen des Werkzeugs in die Verbundschicht reißt bei diesem Verfahren der Film des elektrisch leitenden Materials an den mit Mikrostrukturen versehenen Stellen des Werkzeugs auf. Nach dem Entfernen des Werkzeugs bleiben auf den senkrechten Wänden und auf der Stirnseite der abgeformten Mikrostrukturen kleine, gegeneinander isolierte, inselartige Flitter des elektrisch leitenden Materials zurück. Im Strukturgrund bleibt der Film des elektrisch leitenden Materials dagegen unzerstört erhalten.

Das Verfahren ist nur anwendbar, wenn der Strukturgrund der abgeformten Vertiefungen in der Verbundschicht eine zusammenhängende Fläche bildet, da nur in diesem Fall im Strukturgrund eine elektrisch leitende, als Elektrode schaltbare Schicht ausgebildet wird.

Die Aufgabe der Erfindung besteht darin, ein Verfahren der eingangs genannten Art vorzuschlagen, mit dessen Hilfe eine mikrostrukturierte Kunststoffschicht hergestellt werden kann, die sich auch dann zuverlässig und strukturgenau abformen läßt, wenn das zur Abformung werwendete Werkzeug Mikrostrukturkörper mit einer großen Stirnfläche aufweist. Die durch dieses Verfahren hergestellte mikrostrukturierte Kunststoffschicht soll sich - unabhängig von der Form und der geometrischen Anordnung der Mikrostrukturen - in jedem Fall galvanisch abformen lassen, indem die elektrisch leitende Schicht der Verbundschicht als Elektrode geschaltet wird. Ferner soll ein Werkzeug der eingangs genannten Art zur Durchführung des Verfahrens angegeben werden.

Die Aufgabe der Erfindung wird durch die kennzeichnenden Merkmale des zweiten Patentanspruchs gelöst. Das bei diesem Verfahren eingesetzte Werkzeug wird im Kennzeichen des ersten Patentanspruchs beschrieben.

Das erfindungsgemäße Verfahren geht von einer Verbundschicht aus, die aus einer Schicht eines elektrisch leitenden Materials und aus einer Schicht eines elektrisch nichtleitenden, isolierenden Materials besteht.

Als elektrisch leitendes Material kann das in der eingangs genannten DE 35 37 483 C1 vorgeschlagene mit Leitruß gefüllte Polymethylmethacrylat verwendet werden. Ebenso gut läßt sich mit Metallpulvern gefülltes PMMA einsetzen. Beispielsweise kann das elektrisch leitende Material durch Aufschmelzen eines Gemisches von 10 bis 20 Gew.-% Nickel- und/oder Silberpulver und der entsprechenden Menge PMMA-Pulver hergestellt werden. Weiterhin kann als leitendes Material elektrisch leitender Kunststoff, beispielsweise mit Metallionen dotiertes Polyacetylen oder Polythiophen verwendet werden. Schließlich erscheinen als leitendes Material Fullerene mit eingeschlossenen Metallionen geeignet. Wesentlich ist lediglich, daß das elektrisch leitende Material bei einer höheren Temperatur ausreichend erweicht, so daß sich ein mikrostrukturiertes Werkzeug formtreu abformen läßt, und daß es bei einer niedrigeren Temperatur während der galvanischen Abformung mechanisch ausreichend stabil ist.

Als elektrisch nichtleitendes Material ist PMMA oder ein anderes bei höherer Temperatur formbares Polymer oder Copolymer geeignet.

Die Verbundschicht kann in der in der eingangs genannten DE 35 37 483 C1 beschriebenen Art hergestellt werden, indem z. B. durch Aufgießen und anschließendes Erstarrenlassen des elektrisch leitenden Materials auf eine entfernbare Unterlage die leitende Schicht hergestellt wird, wonach in der selben Weise auf diese Schicht die nicht leitende Schicht aufgetragen wird.

Eine andere Möglichkeit besteht darin, daß eine erste Schicht eines elektrisch leitenden Materials bei erhöhter Temperatur mit einer zweiten Schicht eines elektrisch nicht leitenden Materials verbunden wird.

Die Schicht des elektrisch leitenden Materials muß mindestens so dick sein, daß die Mikrostrukturen des Werkzeugs bei der Abformung diese Schicht nicht durchstoßen. Die obere Grenze der Schichtdicke ergibt sich lediglich aus wirtschaftlichen Überlegungen und aus der Forderung nach einfacher Hantierbarkeit während des Abform- und des nachfolgenden Galvanikverfahrens. Die optimale Schichtdicke hängt ferner vom verwendeten Material ab. Wenn ein mit Ruß oder Metallionen gefülltes PMMA verwendet wird, beträgt die Dicke der elektrisch leitenden Schicht etwa 5 µm bis 10 mm. Vorzugsweise liegt sie im Bereich zwischen 30 µm und 3 mm.

Die Dicke der elektrisch nichtleitenden, isolierenden Schicht hängt von der Rauhigkeit der Stirnflächen der Mikrostrukturkörper auf dem eingesetzten Werkzeug ab. Die Dicke der isolierenden Schicht muß so gewählt werden, daß eine große Zahl von Spitzen und Graten auf der rauhen Stirnfläche der Mikrostrukturkörper die isolierende Schicht durchdringt. Die isolierende Schicht sollte daher mindestens 0,1 µm dick, aber dünner als 20µm sein. Bei einer entsprechenden Rauhigkeit der Stirnflächen der Mikrostrukturkörper auf dem Werkzeug wird die isolierende Schicht vorzugsweise 0,5 µm bis 1 µm dick gewählt.

Die beschriebene Verbundschicht wird anschließend auf eine solche Temperatur erwärmt, bei der das Werkzeug abgeformt werden kann. Besteht die Verbundschicht hauptsächlich aus PMMA, wird die Abformung vorzugsweise bei einer Temperatur oberhalb des Erweichungspunkts, etwa im Temperaturbereich zwischen 110°C und 160°C durchgeführt. Bei wesentlich niedrigeren Temperaturen ist die Verbundschicht zu spröde, so daß sich bei der Abformung Risse bilden können. Bei wesentlich höheren Temperaturen ist die Verbundschicht zu weich, so daß sich die Verbundschicht verziehen kann. Besteht die Verbundschicht aus anderen Materialen, können niedrigere oder höhere Temperaturen besser geeignet sein.

In die elektrisch isolierende Schicht der erwärmten Verbundschicht wird anschließend ein Werkzeug der eingangs genannten Art eingepreßt, das jedoch auf den Stirnflächen der Mikrostrukturkörper eine solche Rauhigkeit aufweist, daß die Spitzen und Grate der rauhen Stirnflächen die elektrisch isolierende Schicht durchstoßen. Im Bereich der Stirnflächen soll die Rauhtiefe Rₜ zwischen 0,1 µm und 10 µm liegen; gut geeignet sind Werkzeuge mit Rₜ zwischen 1 und 5 µm und Rₐ zwischen 0,1 und 0,5 µm. Der Mittenrauhwert soll 0,01 µm bis 1 µm betragen. Wie erwähnt muß die Rauhigkeit der Stirnflächen auf die Dicke der isolierenden Schicht abgestimmt sein.

Die Höhe der Mikrostrukturkörper auf dem Werkzeug muß beim erfindungsgemäßen Verfahren größer sein als die Dicke der isolierenden Schicht. Für die meisten Zwecke werden solche Werkzeuge verwendet, bei denen die Höhe der Mikrostrukturkörper im Bereich zwischen 50 µm und 700 µm beträgt.

Werkzeuge, die für das erfindungsgemäße Verfahren geeignet sind, können nach dem bekannten LIGA (Röntgentiefenlithographie-galvanische Abformung)-Verfahren aus Nickel hergestellt werden, wobei abweichend von der üblichen Verfahrensweise der Galvanoformungsprozeß nach dem Auffüllen der Kunststoff-Mikrostrukturen weitergeführt wird, bis eine ca. 5 mm dicke spannungsarme Nickelplatte entstanden ist, die mechanisch endbearbeitet wird. Zur Erzeugung der Rauhigkeit kann die Endbearbeitung einen Mikrosandstrahlungsschritt enthalten.

Wesentlich ist, daß das Werkzeug auf den Stirnflächen seiner Mikrostrukturkörper die angegebene Rauhigkeit aufweist. Die gleiche Rauhigkeit kann auch auf dem Strukturgrund des Werkzeugs zwischen den Mikrostrukturkörpern verhanden sein. Eine solche Rauhigkeit behindert das erfindungsgemäße Verfahren nicht; im Gegenteil wird dadurch ein vollständiges Übergalvanisieren der mikrostrukturierten Verbundschicht erleichtert, denn dann wird durch die Spitzen und Grate der Rauhigkeit nicht nur im Strukturgrund der Verbundschicht, sondern auch auf der Oberseite die elektrisch leitende Schicht freigelegt. Sollen jedoch nur die durch das Werkzeug geschaffenen Vertiefungen galvanisch ausgefüllt werden, muß ein Werkzeug verwendet werden, das nur an den Stirnflächen der Mikrostrukturkörper rauh ist, damit auf der Oberseite der Verbundschicht die isolierende Schicht erhalten bleibt.

Die Höhe der Mikrostrukturkörper auf dem Werkzeug braucht nicht einheitlich zu sein; erfindungsgemäß können auch solche Werkzeuge verwendet werden, die verschieden hohe Mikrostrukturkörper aufweisen. Die Mikrostrukturkörper können auch ein- oder mehrfach gestuft sein.

Das erfindungsgemäße Verfahren wird im folgenden anhand der Figuren 1 bis 5 veranschaulicht.

Fig. 1 zeigt die verwendete Verbundschicht 1. Im vergrößert gezeichneten Ausschnitt ist die elektrisch leitende Schicht 1a bestehend aus einem Polymer mit eingelagerten leitfähigen Partikeln und die dünne elektrisch isolierende Schicht 1b erkennbar.

Fig. 2 (a) und (b) stellen den Verlauf des Abformvorgangs dar. Das Werkzeug 2 wird in die Verbundschicht eingepreßt, wobei sich der Raum zwischen den Mikrostrukturkörpern des Werkzeugs mit der erwärmten, viskosen Verbundschicht füllt.

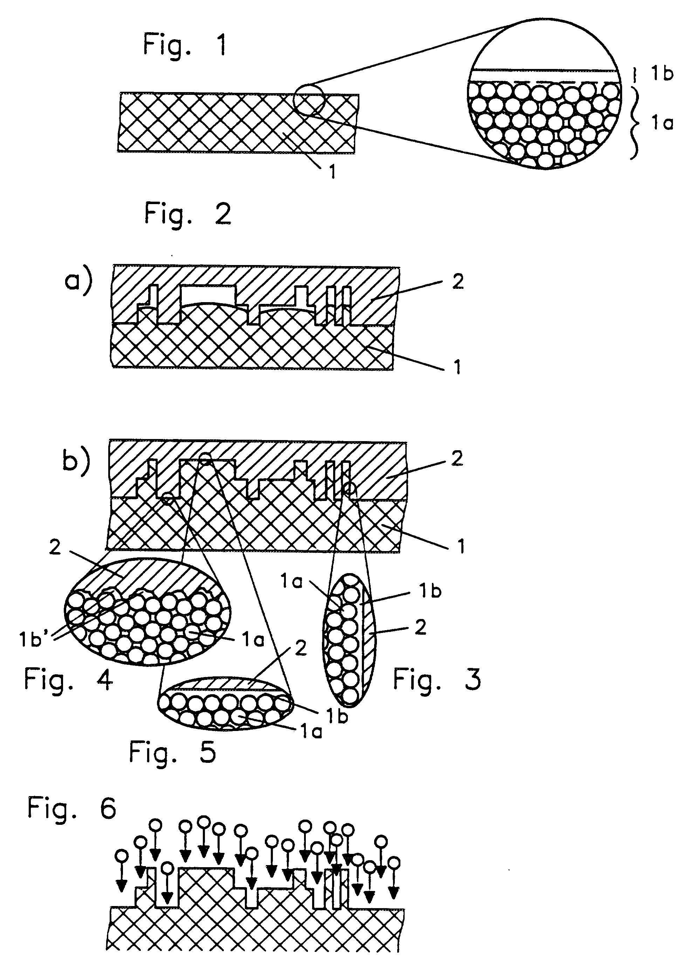

Aus Fig. 3 ist ersichtlich, daß die senkrechten Wände der in der Vernundschicht abgeformten Mikrostruktur mit der isolierenden Schicht 1b überzogen sind.

In Fig. 4 ist dargestellt, daß die rauhen Stirnseiten des Werkzeugs die isolierende Schicht 1b durchstoßen haben, von der lediglich die Reste 1b' übriggeblieben sind.

Fig. 5 zeigt, daß der glatte Strukturgrund des Werkzeugs 2 die dünne isolierende Schicht auf der Oberseite der Verbundschicht unversehrt läßt.

In Fig. 6 ist der nachfolgende Galvanisierungsschritt schematisch dargestellt. Während der Galvanisierung füllt das galvanisch abgeschiedene Metall die Vertiefungen in der Verbundschicht allmählich auf und überdeckt schließlich auch die Oberseite der Verbundschicht.

Das erfindungsgemäße Verfahren weist eine Reihe von Vorteilen auf.

Da erfindungsgemäß galvanisierbare mikrostrukturierte Kunststoffschichten hergestellt werden können, die nur an den senkrechten Seitenwänden der Strukturen mit der isolierenden Schicht überdeckt sind, lassen sich auch große Flächen gestufter Mikrostrukturen übergalvanisieren.

Ein weiterer Vorteil des erfindungsgemäßen Verfahrens ist, daß die nur wenige µm dünne isolierende Schicht auf der Oberfläche der elektrisch leitenden Schicht direkt bei der Herstellung der leitenden Schicht, etwa durch Sedimentierenlassen der leitfähigen Partikel, ausgebildet werden kann. Hierdurch läßt sich der Fertigungsaufwand zur Herstellung der Verbundschicht beträchtlich reduzieren. Wegen der niedrigen Prozeßtemperaturen und Prozeßdrücke lassen sich kleine und kostengünstige Fertigungseinrichtungen einsetzen, mit denen dennoch eine formtreu und ohne Hohlräume galvanisierbare Kunststoffschicht erhalten wird.

Die Erfindung wird im folgenden anhand von Durchführungsbeispielen näher erläutert.

### Beispiel 1

### Herstellung des Werkzeugs

Das Werkzeug wurde ausgehend von einer durch Mikrosandstrahlen vorbehandelten Kupfergrundplatte gefertigt. Die Platte wurde mit einer Schicht von PMMA überzogen, die durch die bekannten Verfahren der Röntgentiefenlithographie strukturiert, d.h. bereichsweise entfernt und anschließend galvanisch mit Nickel abgeformt wurde. Die Stirnflächen der Mikrostrukturkörper auf dem Nickelwerkzeug wiesen eine Rauhigkeit mit Rₐ=1,35 µm und Rₜ=7,2 µm auf.

Der mikrostrukturierte Bereich des Werkzeugs war auf einer Fläche von ca. 500 mm aus insgesamt 74400 honigwabenförmigen Formnestern aufgebaut. Der Innendurchmesser der Waben betrug 80 µm, die Stegbreite der Seitenwände 8 µm und die Höhe der Mikrostrukturkörper ca 180 µm.

### Beispiel 2

### Abformung des gemäß Beispiel 1 hergestellten Werkzeugs in einer Verbundschicht

Zunächst wird aus einem silbergefüllten Gießharz im Reaktionsguß die Verbundschicht hergestellt. Dazu wird der Gießansatz
30 g Polymethylmethacrylat (unvernetzt),
70 g Methylmethacrylat,
4 g Trennmittel PAT 665 (Fa. Würtz Bingen),
2 g Dibenzoylperoxid,
2 g N,N-Dimethylanilin,
285 g Silberpulver (Fa. Demetron, Typ 6321-8000)
bei Raumtemperatur vermischt, in einen Formrahmen mit Boden gegossen und unter Druck (ca. 2 MPa) bei Raumtemperatur angehärtet und anschließend bei Umgebungsdruck und 120°C nachgehärtet.

In einer konventionellen Metallform mit einem Boden aus Aluminium konnte eine elektrisch leitende, silbergefüllte PMMA-Schicht erzeugt werden, in dem auf das Aluminium vor dem Aufgießen des gefüllten PMMA eine reine MMA-Schicht aufgebracht wird, wodurch sich im Verlauf der Aushärtung eine ca. 0,5 µm bis 1 µm dicke füllstofffreie, elektrisch isolierende PMMA-Schicht am Boden der Gießform ausbildet. Schichten mit unterschiedlichen Dicken können durch Aufschleudern von PMMA-Lösungen mit unterschiedlichem Gehalt an leitenden Partikeln hergestellt werden.

Auf die isolierende Schicht der Verbundschicht wurde nun unter Vakuum das gemäß Beispiel 1 hergestellte Werkzeug bei einer Temperatur von ca. 115°C aufgepreßt. Nach dem Abkühlen konnte die strukturierte Verbundschicht entformt werden. Die mikrostrukturierte Kunststoffschicht kann anschließend direkt galvanisch mit Metall gefüllt werden.

### Beispiel 3

### Herstellung einer weiteren Verbundschicht

Zur Herstellung der Verbundschicht wurde zunächst auf einem Dreiwalzenstuhl ein elektrisch leitender, rußgefüllter Thermoplast hergestellt. Als Leitfähigkeitsruß wurden 12.5 Gewichtsprozent Printex XE2 (Fa. Degussa) in 87.5 Gewichtsprozent der PMMA-Spritzgußformmasse Degalan G6 (Fa. Degussa) eingearbeitet. Der Thermoplast wurde anschließend unter einer beheizbaren Laborpresse zu einer Platte mit einer Fläche von 100 · 100 mm' und einer Dicke von 4 mm geformt. Durch die Wahl eines geeigneten Temperaturprogramms beim Pressen konnte eine Verbundschicht hergestellt werden mit einer 0,5 bis 1 µm dicken elektrisch isolierenden Schicht. Die Verbundschicht wurde wie in Beispiel 2 angegeben weiterverarbeitet.

## Patentansprüche

1. Werkzeug zum Prägen von galvanisch abformbaren Kunststoffschichten
- mit einer Grundplatte und
- einer Vielzahl von auf der Grundplatte angebrachten erhabenen Mikrostrukturkörpern mit parallel zur Grundplatte angeordneten Stirnflächen,
dadurch gekennzeichnet, daß
die Stirnflächen eine Rauhigkeit mit einer Rauhtiefe Rₜ im Bereich zwischen 0,1 µm und 10 µm bei einem Mittenrauhwert Rₐ von 0,01 µm bis 1 µm aufweisen.

2. Verfahren zur Herstellung einer mikrostrukturierten, galvanisch abformbaren Kunststoffschicht, bei dem
a) eine Verbundschicht bestehend aus einer elektrisch leitenden Schicht und einer elektrisch isolierenden Schicht hergestellt wird,
b) die Verbundschicht erwärmt wird,
c) in die elektrisch isolierende Schicht der erwärmten Verbundschicht ein Werkzeug mit einer Vielzahl von auf einer Grundplatte angebrachten erhabenen Mikrostukturkörpern, deren Stirnflächen parallel zur Grundplatte verlaufen, eingepreßt wird, wobei
d) die Höhe der erhabenen Mikrostruktürkörper mindestens der Dicke der elektrisch isolierenden Schicht entspricht,
dadurch gekennzeichnet, daß
e) ein solches Werkzeug eingesetzt wird, bei dem
- die Stirnflächen der erhabenen Mikrostrukturkörper eine Rauhigkeit mit einer Rauhtiefe Rt im Bereich zwischen 0,1 µm und 10 µm bei einem Mittenrauhwert Rₐ von 0,01 µm bis 1 µm aufweisen und die isolierende Schicht 0,1 µm bis 20 µm dick gewählt wird, wobei
- die Rauhigkeit der Stirnflächen so bemessen ist, daß die Spitzen und Grate der rauhen Stirnflächen die elektrisch isolierende Schicht durchstoßen.

## Claims

1. Tool for embossing galvanically deformable plastics material layers,
- having a base plate and
- a plurality of raised microstructured bodies, which are mounted on the base plate and have end faces disposed parallel to the base plate,
characterised in that
the end faces have a roughness with a depth of roughness Rₜ in the range of between 0.1 µm and 10 µm with a mean roughness value of between 0.01 µm and 1 µm.

2. Method of producing a microstructured, galvanically deformable plastics material layer, wherein
a) a composite layer is produced, comprising an electrically conductive layer and an electrically insulating layer,
b) the composite layer is heated,
c) a tool, having a plurality of raised microstructured bodies which are mounted on a base plate and have end faces extending parallel to the base plate, is pressed into the electrically insulating layer of the heated composite layer,
d) the height of the raised microstructured bodies corresponding to at least the thickness of the electrically insulating layer,
characterised in that
e) such a tool is used, wherein
- the end faces of the raised microstructured bodies have a roughness with a depth of roughness Rₜ in the range of between 0.1 µm and 10 µm with a means roughness value Rₐ of between 0.01 µm and 1 µm, and the insulating layer is selected to have a thickness of between 0.1 µm and 20 µm,
- the roughness of the end faces being so dimensioned that the tips and burrs of the rough end faces pierce the electrically insulating layer.

## Revendications

1. Outil pour estamper des couches en matière plastique moulables par électrodéposition,
- avec une plaque de base et,
- une pluralité de corps microstructurés formés sur la plaque de base avec des faces frontales disposées parallèlement à la plaque de base,
caractérisé en ce que les faces frontales présentent une rugosité ayant une profondeur de rugosité Rₜ dans l'intervalle compris entre 0,1 µm et 10 µm pour une rugosité moyenne Rₐ de 0,01 µm à 1 µm.

2. Procédé de préparation d'une couche en matière plastique moulable par électrodéposition microstructurée, où on prépare :
a) une couche composite constituée d'une couche électriquement conductrice et une couche électriquement isolante,
b) on chauffe la couche composite,
c) dans la couche électriquement isolante de la couche composite on enfonce sous pression un outil ayant une pluralité de corps microstructurés formés et disposés sur une plaque de base dont les faces frontales s'étendent parallèlement à la plaque de base, où,
d) la hauteur des corps microstructurés obtenus correspond aux moins à l'épaisseur de la couche électriquement isolante,
caractérisé en ce que,
e) on utilise un outil tel que,
- les faces frontales des corps microstructurés obtenus présentent une rugosité avec une profondeur de rugosité Rₜ dans l'intervalle compris entre 0,1 µm et 10 µm pour une valeur moyenne de rugosité Rₐ de 0,1 µm à 20 µm, ou
- la rugosité des faces frontales est d'importance telle que les pointes et barbes des faces frontales rugueuses transpercent la couche électriquement isolante.
